# EUROPEAN PATENT APPLICATION

(11) **EP 4 841 282 A1**
(43) Date of publication of application: **18.11.2026**
(21) Application number: 24916924.4
(22) Date of filing: 24.12.2024
(51) Int. Cl.: G01R 31/392, G01R 31/367, G01R 31/382, G01R 31/385, H01M 10/48, H02J 7/00

(54) **BATTERY ANALYSIS SYSTEM, BATTERY ANALYSIS METHOD, AND BATTERY ANALYSIS PROGRAM**

(30) Priority: 12.01.2024 JP 2024003171
(71) Applicant: Panasonic Intellectual Property Management Co., Ltd., Kadoma-shi, Osaka 571-0057 (JP)
(72) Inventor: YANG, Changhui, Kadoma-shi, Osaka 571-0057 (JP); TANIKAWA, Masahiro, Kadoma-shi, Osaka 571-0057 (JP)
(74) Representative: Novagraaf International SA
(86) International application number: PCT/JP2024/045792
(87) International publication number: WO 2025/150422

(57) **Abstract**

An SOH calculator calculates a plurality of state of health (SOH) values of a secondary battery based on an SOC difference between two points obtained with reference to battery data and a current integration value. A degradation prediction formula generator generates a degradation prediction formula (SOH = m + K ^{x} X^f) of the secondary battery by performing curve fitting on a plurality of calculated SOH values. A degradation rate statistical value calculator calculates a statistical value of a degradation rate of the secondary battery in an (n+1)-th use based on measured or predicted battery data of the secondary battery after a start of the (n+1)-th use and degradation characteristics of the secondary battery. The degradation prediction formula generator corrects the degradation rate of the degradation prediction formula in the n-th use of the secondary battery based on a ratio between a statistical value of the degradation rate in the n-th use calculated from the degradation characteristics of the secondary battery and a statistical value of the degradation rate in the (n+1)-th use calculated from the degradation characteristics of the secondary battery, and generates the degradation prediction formula in the (n+1)-th use.

## Description

### TECHNICAL FIELD

The present disclosure relates to a battery analysis system, a battery analysis method, and a battery analysis program for analyzing an internal state of a secondary battery.

### BACKGROUND ART

Some secondary batteries are operated such that first use is ended in accordance with a predetermined criterion and second use is started. As the predetermined criterion, for example, a decrease in a state of health (SOH) to a set value is often used. When a manner of use of the secondary battery and operating environment of the secondary battery change, it is assumed that the degradation trend of the SOH changes.

Patent Literature 1 discloses a remaining life prediction device that predicts a remaining life of a lithium-ion battery. In the remaining life prediction device, the second difference is calculated based on capacity measurement data {tn, C(tn)}, and an inflection point is specified from a sign change thereof. When an inflection point is present in the measurement range, a convex function portion is determined by fitting for capacity measurement data of cycles smaller than the inflection point. For capacity measurement data of cycles larger than the inflection point, a concave function portion is determined by fitting. That is, Patent Literature 1 discloses that the inflection point is extracted from a distribution of capacity measurement data, and a polynomial to be fitted is changed before and after the inflection point to perform remaining life prediction.

### Citation List

### Patent Literature

Patent Literature 1: Japanese Patent Unexamined Publication No. 2011-208966

### SUMMARY OF THE INVENTION

However, when degradation prediction is performed by also using data from before changes in the manner of use of a secondary battery and in the environment of the secondary battery, prediction accuracy is reduced.

The present disclosure has been made in view of such circumstances, and an object of the present disclosure is to provide a technique for predicting, with high accuracy, degradation progression after a change in the manner of use of the secondary battery.

A battery analysis system according to an aspect of the present disclosure includes: a data acquirer that acquires battery data of the secondary battery, the battery data being time-series data, the battery data including a current, a temperature, and a state of charge (SOC); a state of health (SOH) calculator that calculates a plurality of SOH values of the secondary battery based on an SOC difference between two points and a current integration value, the SOC difference and the current integration value being obtained with reference to the battery data; a degradation prediction formula generator that generates a degradation prediction formula (SOH = m + K × X^f) of the secondary battery by performing curve fitting on the plurality of SOH calculated values; and a degradation rate statistical value calculator that calculates a statistical value of a degradation rate of the secondary battery based on the battery data of the secondary battery and degradation characteristics of the secondary battery. The degradation rate statistical value calculator calculates the statistical value of the degradation rate of the secondary battery in an (n+1)-th use (n being a natural number) based on (i) the battery data of the secondary battery that is measured or predicted after a start of the (n+1)-th use of the secondary battery following an n-th use of the secondary battery, and (ii) the degradation characteristics of the secondary battery, and the degradation prediction formula generator corrects a degradation rate K of the degradation prediction formula in the n-th use of the secondary battery based on a ratio between (i) a statistical value of a degradation rate in the n-th use calculated from the degradation characteristics of the secondary battery and (ii) the statistical value of the degradation rate in the (n+1)-th use calculated from the degradation characteristics, to generate the degradation prediction formula in the (n+1)-th use.

Any combination of the aforementioned constituent elements, and forms obtained by converting the expressions of the present disclosure among devices, systems, methods, and computer programs are also effective as aspects of the present disclosure.

According to the present disclosure, it is possible to predict the degradation progression after a change in the manner of use of the secondary battery with high accuracy.

### BRIEF DESCRIPTION OF THE DRAWINGS

[Fig. 1] FIG. 1 is a diagram illustrating a schematic configuration of an electric vehicle according to an embodiment.
[Fig. 2] FIG. 2 is a diagram for describing a battery analysis system according to the embodiment.
[Fig. 3] FIG. 3 is a diagram illustrating a configuration example of the battery analysis system according to the embodiment.
[Fig. 4] FIG. 4 is a diagram illustrating an example of a storage degradation characteristic map.
[Fig. 5A] FIG. 5A is a diagram illustrating an example of a charge degradation characteristic map.
[Fig. 5B] FIG. 5B is a diagram illustrating an example of a discharge degradation characteristic map.
[Fig. 6] FIG. 6 is a diagram illustrating a specific image of an FCC estimation method.
[Fig. 7] FIG. 7 is a graph illustrating an example of a degradation prediction formula of a battery pack.
[Fig. 8] FIG. 8 is a flowchart for describing degradation prediction processing during second use of the battery pack according to the embodiment.

### DESCRIPTION OF EMBODIMENT

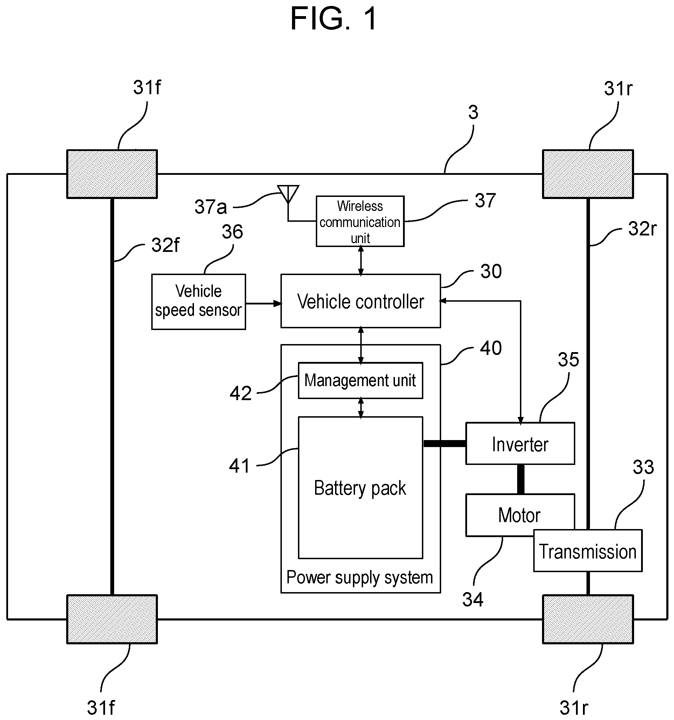

FIG. 1 is a diagram illustrating a schematic configuration of an electric vehicle 3 according to an embodiment. In the present embodiment, the electric vehicle 3 is assumed to be a pure electric vehicle (EV) without an internal combustion engine. The electric vehicle 3 illustrated in FIG. 1 is a rear wheel drive (2WD) EV including a pair of front wheels 31f, a pair of rear wheels 31r, and a motor 34 as a power source. The pair of front wheels 31f are connected by a front axle 32f, and the pair of rear wheels 31r are connected by a rear axle 32r. A transmission 33 transmits rotation of the motor 34 to the rear axle 32r at a predetermined conversion ratio. The electric vehicle 3 may be a front wheel drive (2WD) electric vehicle or a 4WD electric vehicle.

A power supply system 40 includes a battery pack 41 and a management unit 42. The battery pack 41 includes a plurality of single cells connected in series or a plurality of parallel cells connected in series. Each parallel cell includes a plurality of single cells connected in parallel. In the case of the battery pack 41 having a large number of single cells connected in series or a large number of parallel cells connected in series, the battery pack 41 may be configured by connecting in series a plurality of battery modules each including single cells connected in series or parallel cells connected in series.

As the cell, a lithium-ion battery cell or a nickel-metal hydride battery cell can be used. Hereinafter, in the present specification, an example in which a lithium-ion battery cell (nominal voltage: 3.6-3.7 V) is used is assumed. The number of single cells connected in series or the number of parallel cells connected in series is determined according to the voltage of the motor 34.

The management unit 42 manages the state of the battery pack 41. The management unit 42 monitors, as monitoring data items of the battery pack 41, the cell voltage, measured by a voltage sensor (not shown), of each single cell or of each parallel cell, a current flowing through the battery pack 41 measured by a current sensor (not shown), and respective temperatures measured by a plurality of temperature sensors (not shown) installed in the battery pack 41.

The management unit 42 acquires the monitored cell voltages, current, and temperatures at a predetermined sampling cycle (for example, 10 seconds), and stores the monitored cell voltages, current, and temperatures in a nonvolatile memory (not shown). The management unit 42 may store only the maximum cell voltage and the minimum cell voltage among the cell voltages in order to reduce the amount of stored data. The management unit 42 may store only the maximum temperature and the minimum temperature among the temperatures at a plurality of observation points in order to reduce the amount of stored data.

The management unit 42 estimates an SOC by combining an open-circuit voltage (OCV) method and a current integration method. The OCV method is a method of estimating the SOC based on the measured OCV of the cell and the SOC-OCV curve of the cell. The SOC-OCV curve of the cell is created in advance based on a characteristic test by a battery manufacturer, and is registered in the management unit 42 at the time of shipment.

The current integration method is a method of estimating the SOC based on the OCV at the start of charge and discharge of the cell and the integrated value of the measured current. In the current integration method, as the charge/discharge time becomes longer, a measurement error of the current accumulates. Therefore, it is preferable to use a weighted average of the SOC estimated by the current integration method and the SOC estimated by the OCV method.

The management unit 42 can convert the SOC of each single cell or each parallel cell into actual capacities, calculate the actual capacity of the battery pack 41 by combining the actual capacities, and estimate the SOC of the battery pack 41 based on the actual capacity of the battery pack 41 and the current full charge capacity of the battery pack 41.

The management unit 42 transmits battery data of the battery pack 41, including each cell voltage or the maximum and minimum cell voltages, current, each temperature or the maximum and minimum temperatures, and the SOC, to a vehicle controller 30 via the in-vehicle network. For example, a controller area network (CAN) or a local interconnect network (LIN) can be used as the in-vehicle network.

In the EV, a three-phase AC motor is generally used as the motor 34 for driving. During power running, an inverter 35 converts DC power supplied from the battery pack 41 into AC power to supply the AC power to the motor 34. During regeneration, the inverter 35 converts AC power supplied from the motor 34 into DC power to supply the DC power to the battery pack 41. During power running, the motor 34 rotates in accordance with AC power supplied from the inverter 35. During regeneration, the motor 34 converts rotational energy due to deceleration into AC power to supply the AC power to the inverter 35.

The vehicle controller 30 is a vehicle electronic control unit (ECU) that controls the entire electric vehicle 3, and may be constituted by, for example, an integrated vehicle control module (VCM).

A vehicle speed sensor 36 generates a pulse signal proportional to the rotational speed of the front axle 32f or the rear axle 32r, and transmits the generated pulse signal to the vehicle controller 30. The vehicle controller 30 detects the speed of the electric vehicle 3 based on the pulse signal received from the vehicle speed sensor 36. The vehicle controller 30 calculates the travel distance of the electric vehicle 3 based on the temporal changes of the speed of the electric vehicle 3.

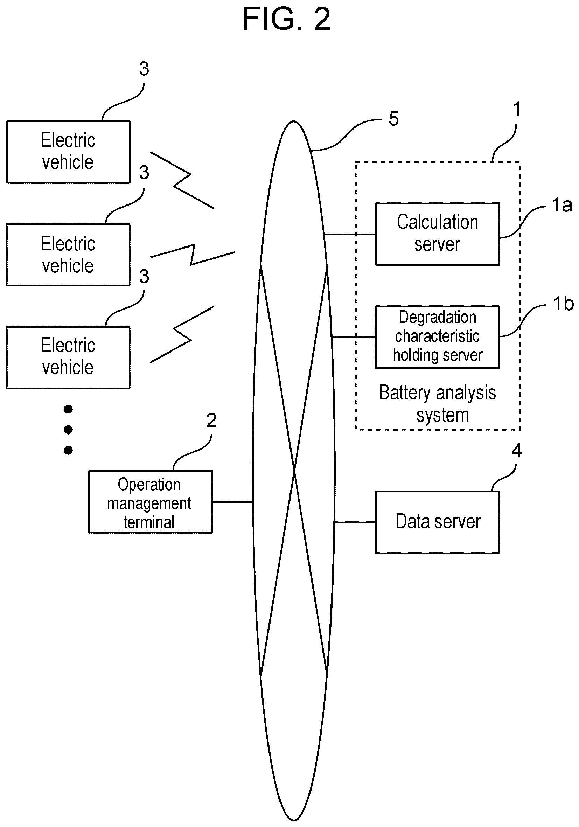

A wireless communication unit 37 includes a modem for wirelessly connecting to a network 5 (see FIG. 2) via an antenna 37a, and performs wireless signal processing. For example, a mobile phone network (cellular network), a wireless LAN, vehicle-to-infrastructure (V2I), vehicle-to-vehicle (V2V), an electronic toll collection (ETC) system, or dedicated short-range communications (DSRC) can be used.

While the electric vehicle 3 is traveling, the vehicle controller 30 can transmit travel data from the wireless communication unit 37 to a data server 4 (see FIG. 2) via the network 5 in real time. The travel data includes at least the vehicle speed of the electric vehicle 3, the cumulative travel distance, and the battery data received from the management unit 42. The vehicle controller 30 samples these data periodically (for example, at intervals of 10 seconds) and transmits the data to the data server 4 each time.

The vehicle controller 30 may accumulate the travel data of the electric vehicle 3 in an internal memory and collectively transmit the travel data accumulated in the memory at a predetermined timing. For example, after the end of business of one day, the vehicle controller 30 may collectively transmit the travel data accumulated in the memory to an operation management terminal 2 (see FIG. 2) installed at a delivery base. The operation management terminal 2 transmits the travel data of a plurality of electric vehicles 3 to the data server 4 at each predetermined timing.

The vehicle controller 30 may collectively transmit the travel data accumulated in the memory to a charger via a charging cable at the time of charging from the charger having a network communication function. The charger transmits the received travel data to the data server 4. This example is effective for the electric vehicle 3 not equipped with a wireless communication function.

FIG. 2 is a diagram for describing a battery analysis system 1 according to the embodiment. The battery analysis system 1 according to the embodiment is a system used by at least one delivery business operator. The battery analysis system 1 may be constructed, for example, on an in-house server installed in an in-house facility of a battery analysis service provider or installed in a data center of the battery analysis service provider, the battery analysis service provider providing an analysis service for the battery pack 41 mounted on the electric vehicle 3. The battery analysis system 1 may be constructed on a cloud server used based on a cloud service. The battery analysis system 1 may be constructed on a plurality of servers installed in a distributed manner at a plurality of sites (data centers, in-house facilities). The plurality of servers may be a combination of a plurality of in-house servers, a combination of a plurality of cloud servers, or a combination of an in-house server and a cloud server. In the example shown in FIG. 2, the battery analysis system 1 is constructed by a calculation server 1a and a degradation characteristic holding server 1b.

The delivery business operator owns a plurality of electric vehicles 3 and has the delivery base for parking the electric vehicles 3. The operation management terminal 2 is installed at the delivery base. The operation management terminal 2 is constituted by, for example, a PC. The operation management terminal 2 is used to manage the plurality of electric vehicles 3 belonging to the delivery base. An operation manager of the delivery business operator can use the operation management terminal 2 to create an operation plan for the plurality of electric vehicles 3.

The operation management terminal 2 can access the battery analysis system 1 via the network 5. The operation management terminal 2 acquires analysis results of the battery pack 41 mounted on each electric vehicle 3 from the battery analysis system 1. The analysis results of the battery pack 41 includes the remaining life of the battery pack 41.

The data server 4 acquires and accumulates the travel data from the operation management terminal 2 or the electric vehicle 3. The data server 4 may be an in-house server installed in an in-house facility of the delivery business operator or the battery analysis service provider, or in a data center, or may be a cloud server used by the delivery business operator or the battery analysis service provider. Each delivery business operator and the battery analysis service provider may have their own data server 4.

The network 5 is a general term for communication paths such as the Internet, a dedicated line, and a virtual private network (VPN), and a communication medium and a protocol thereof do not matter. As the communication medium, for example, a mobile phone network (cellular network), a wireless LAN, a wired LAN, an optical fiber network, an ADSL network, or a CATV network can be used. As the communication protocol, for example, Transmission Control Protocol/Internet Protocol (TCP/IP), User Datagram Protocol/Internet Protocol (UDP/IP), or Ethernet (registered trademark) can be used.

In a state where the electric vehicle 3 is parked at the delivery base, the vehicle controller 30 and the operation management terminal 2 can exchange data with each other via the network 5 (for example, a wireless LAN) or a CAN cable. The vehicle controller 30 and the operation management terminal 2 may be configured to be able to exchange data via the network 5 even while the electric vehicle 3 is traveling.

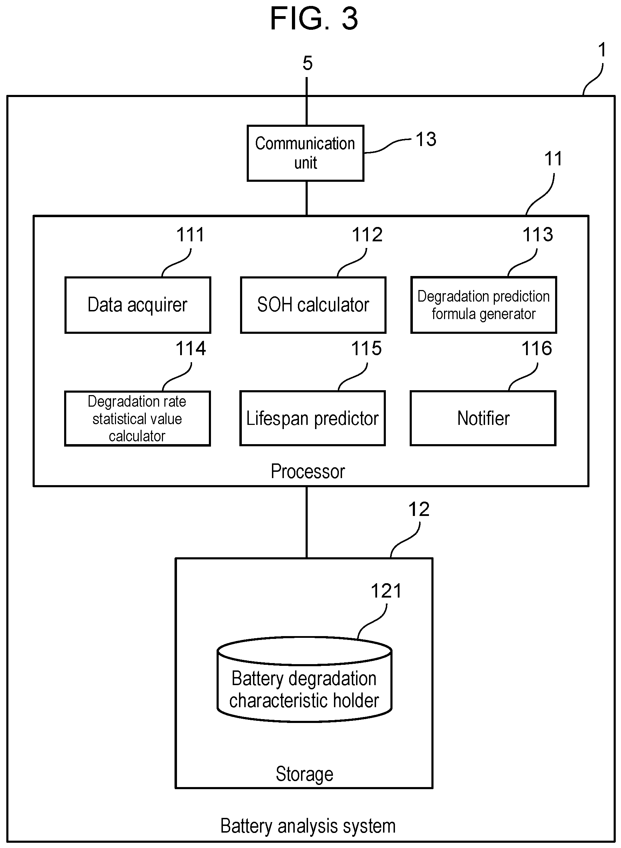

FIG. 3 is a diagram illustrating a configuration example of the battery analysis system 1 according to the embodiment. The battery analysis system 1 includes a processor 11, a storage 12, and a communication unit 13. The communication unit 13 is a communication interface (for example, a network interface card (NIC)) for connecting to the network 5 in a wired or wireless manner.

The processor 11 includes a data acquirer 111, an SOH calculator 112, a degradation prediction formula generator 113, a degradation rate statistical value calculator 114, a lifespan predictor 115, and a notifier 116. The function of the processor 11 can be realized by cooperation of hardware resources and software resources, or hardware resources alone. The hardware resources may include a Central Processing Unit (CPU), a Read Only Memory (ROM), a Random Access Memory (RAM), a Graphics Processing Unit (GPU), a Neural network Processing Unit (NPU), an Application Specific Integrated Circuit (ASIC), a Field Programmable Gate Array (FPGA), and other Large Scale Integrated (LSI) circuits. Programs such as operating systems and applications can be used as software resources.

The storage 12 includes a non-volatile recording medium such as an HDD or an SSD, and stores various types of data. The storage 12 includes a battery degradation characteristic holder 121. The battery degradation characteristic holder 121 holds storage degradation characteristics, charge degradation characteristics, and discharge degradation characteristics for each type of a secondary battery.

The battery degradation characteristic holder 121 holds, as battery information for specifying the type of the secondary battery, at least one of a model number, a model type, a cell shape, a positive electrode material, a composition ratio of the positive electrode material, a negative electrode material, a composition ratio of the negative electrode material, a gravimetric energy density, or a volumetric energy density. Data in the battery degradation characteristic holder 121 is updated every time a new type of the secondary battery is registered. When characteristic information of an already registered secondary battery is updated, the data in the battery degradation characteristic holder 121 is also updated.

Storage degradation of the secondary battery is degradation that progresses over time according to the temperature of the secondary battery at each point in time and the SOC at each point in time. It progresses with the passage of time regardless of whether charging or discharging is being performed. The storage degradation occurs mainly due to formation of a film (solid electrolyte interphase (SEI) film) on the negative electrode. The storage degradation depends on the SOC at each point in time and the temperature at each point in time. In general, the higher the SOC at each point in time and the higher the temperature at each point in time, the higher a storage degradation rate.

Charge/discharge degradation of the secondary battery is degradation that progresses as the number of charge/discharge cycles increases. The charge/discharge degradation occurs mainly due to cracking or peeling caused by expansion or contraction of the active material. The charge/discharge degradation depends on an SOC range, temperature, and a C-rate. In general, a charge/discharge degradation rate increases as the SOC range becomes wider, the temperature becomes higher, and the C-rate becomes higher.

The storage degradation characteristics, the charge degradation characteristics, and the discharge degradation characteristics are derived in advance for each type of the secondary battery by an experiment conducted by a battery manufacturer or a simulation conducted by a battery manufacturer.

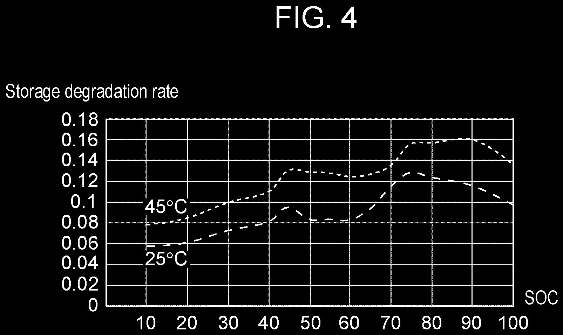

FIG. 4 is a diagram illustrating an example of a storage degradation characteristic map. The horizontal axis represents the SOC [%], and the vertical axis represents the storage degradation rate [%/T^f1]. The storage degradation is described by a model in which the storage degradation progresses linearly with respect to elapsed time T(h) raised to the power from 0.5 to 1.0. In general, the storage degradation is described by a model in which the storage degradation progresses linearly with respect to the square-root law (f1 = 0.5) of elapsed time T(h).

In FIG. 4, for simplicity, only the storage degradation characteristics for two temperatures of 25°C and 45°C are shown. However, in practice, the storage degradation characteristics for a large number of temperatures are generated. The storage degradation characteristics may be defined by a function, rather than a map with the SOC and the temperature as explanatory variables and the storage degradation rate as an objective variable.

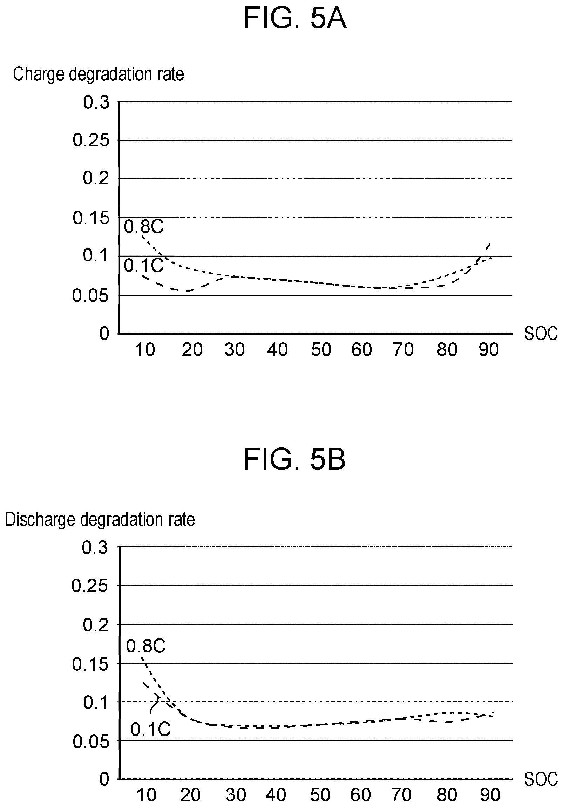

FIG. 5A illustrates an example of a charge degradation characteristic map, and FIG. 5B illustrates an example of a discharge degradation characteristic map. The horizontal axis represents the SOC range [%]. In FIGS. 5A and 5B, the value of each SOC indicates a lower limit value of an SOC range of 10%. For example, SOC10% indicates that charging and discharging are performed within an SOC range of 10 to 20%, and SOC11% indicates that charging and discharging are performed within an SOC range of 11 to 21%. The vertical axis represents a charge degradation rate [%/E^f2] or the discharge degradation rate [%/E^f3].

The charge/discharge degradation is described by a model in which the charge/discharge degradation progresses linearly with respect to cumulative charge amount E(Ah) raised to the power from 0.5 to 1.0 or cumulative discharge amount E(Ah) raised to the power from 0.5 to 1.0. In general, the charge/discharge degradation is described by a model in which the charge/discharge degradation progresses linearly with respect to the square-root law (f2, f3 = 0.5) of the cumulative charge amount E(Ah) or of the cumulative discharge amount E(Ah). As the cumulative charge amount E or the cumulative discharge amount E, cumulative charge energy (kWh) or cumulative discharge energy (kWh) may be used instead of cumulative charge current amount (Ah) or cumulative discharge current amount (Ah).

In FIGS. 5A and 5B, for simplicity, only charge/discharge degradation characteristics for two types of C-rates of 0.1 C and 0.8 C are drawn. However, in practice, the charge/discharge degradation characteristics for a large number of the C-rates are generated. At the time of charging, as shown in FIG. 5A, it can be seen that the degradation rate increases in a region where the SOC range is low and a region where the SOC range is high. At the time of discharging, as shown in FIG. 5B, it can be seen that the degradation rate increases in a region where the SOC range is low.

In addition, the charge/discharge degradation characteristics are also affected by temperature although the contribution thereof is not as large as that of the C-rate. Therefore, in order to improve the estimation accuracy of the charge/discharge degradation rate, it is preferable to prepare the charge/discharge degradation characteristics defining a relationship between the SOC range and the charge/discharge degradation rate for each two-dimensional combination of a plurality of the C-rates and a plurality of temperatures. On the other hand, when a simple charge/discharge degradation characteristic map is generated, it is only necessary to regard temperature as room temperature and prepare the charge/discharge degradation characteristics for each of a plurality of the C-rates.

The charge/discharge degradation characteristics may be defined not by a map but by a function having the SOC range, the C-rate, and temperature as explanatory variables and the charge/discharge degradation rate as an objective variable. Temperature may be a constant.

Discharge degradation of the secondary battery included in the battery pack 41 mounted on the electric vehicle 3 can also be described by a model in which the discharge degradation progresses linearly with respect to the 0.5 to 1.0 power of the cumulative travel distance D(km) of the electric vehicle 3. In that case, the unit of the discharge degradation rate is [%/D^f4]. In general, the discharge degradation is described by a model in which the discharge degradation progresses linearly with respect to the square-root law (f4 = 0.5) of the cumulative travel distance D(km) of the electric vehicle 3.

Returning to FIG. 3, the data acquirer 111 acquires time-series battery data including the current of the battery pack 41, the temperature of the battery pack 41, and the SOC of the battery pack 41 from the data server 4. For example, battery data of the past one year or more is acquired.

The SOH calculator 112 calculates a plurality of SOH values of the battery pack 41 by a two-point OCV method using an SOC difference between two points and a current integration value, each obtained with reference to the time-series battery data. Specifically, the SOH calculator 112 obtains an SOC difference (ΔSOC) between an SOC in a first rest state and an SOC in a second rest state based on the voltage of the battery pack 41 in the first rest state, the voltage of the battery pack 41 in the second rest state, and the SOC-OCV curve. The SOH calculator 112 obtains an integration current value Q in a period between the first rest state and the second rest state based on a value of the current included in the battery data. The SOH calculator 112 obtains the current full charge capacity (FCC) of the battery pack 41 based on the current integration value Q and ΔSOC. The SOH calculator 112 calculates the SOH based on a ratio between the current FCC of the battery pack 41 and the initial FCC of the battery pack 41.

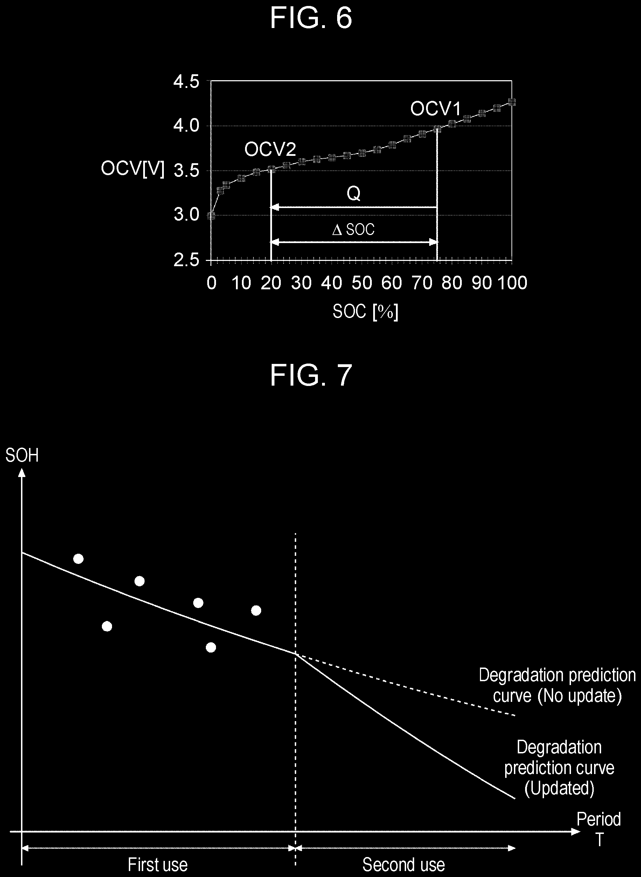

FIG. 6 is a diagram illustrating a specific image of the FCC estimation method. The SOH calculator 112 identifies voltages at two points in the first rest state and the second rest state, and sets the voltages as OCVs at the two points. The SOH calculator 112 refers to the SOC-OCV curve, identifies SOCs at two points corresponding to the OCVs at the two points, and calculates ΔSOC between the SOCs at the two points. In the example shown in FIG. 6, the SOCs at the two points are 20% and 75%, and ΔSOC is 55%.

The SOH calculator 112 calculates a current integration value (= charge/discharge capacity) Q between two points at which the OCVs are acquired. The SOH calculator 112 estimates the FCC by calculating the following equation (Equation 1).$FCC = Q / ΔSOC$ (Equation 1)

The SOH is defined as the ratio of the current FCC to the initial FCC, and a lower numerical value (closer to 0%) indicates that degradation is progressing. The SOH calculator 112 estimates the SOH by calculating the following equation (Equation 2).$SOH = current FCC / initial FCC \times 100$ (Equation 2) The SOH calculator 112 calculates the SOH at regular intervals (for example, every month, every two weeks, or every week) using the above two-point OCV method on the basis of the time-series battery data.

The degradation prediction formula generator 113 generates a degradation prediction formula (SOH = m + K × X^f) of the battery pack 41 by performing curve fitting using sample data of a plurality of SOH values in time series calculated by the SOH calculator 112. For example, the least squares method can be used for the curve fitting.

FIG. 7 is a graph illustrating an example of a degradation prediction formula of the battery pack 41. The storage degradation of the battery pack 41 progresses linearly with respect to elapsed time T(h) raised to the power of f1, as shown in the following equation (Equation 3).$SOHs = m + Ks \times {T}^{∧} f 1$ (Equation 3) Here, m is an initial value, and Ks is a storage degradation rate.

m is common, and is usually set in a range of 1.0 to 1.1. When the actual initial capacity matches the nominal value, m is set to 1.0. When the nominal value is set to a minimum guaranteed amount and is set lower than the actual initial capacity, m is set to a value greater than 1.0.

The degradation prediction formula generator 113 fits a plurality of SOH values in time series to determine, in the above equation (Equation 3), the storage degradation rate Ks and the exponent f1. A fixed value (for example, 0.5) may be used as the exponent f1.

Charge degradation of the battery pack 41 progresses linearly with respect to the charge amount E(Ah) raised to the power of f2, as shown in the following equation (Equation 4).$SOHc = m + Kc \times {E}^{∧} f 2$ (Equation 4) Here, m is an initial value, and Kc is a charge degradation rate.

The degradation prediction formula generator 113 fits a plurality of SOH values in time series to determine, in the above equation (Equation 4), the charge degradation rate Kc and the exponent f2. A fixed value (for example, 0.5) may be used as the exponent f2.

Discharge degradation of the battery pack 41 progresses linearly with respect to the f3 power of the discharge amount E(Ah) as shown in the following equation (Equation 5). Alternatively, as shown in the following equation (Equation 6), the discharge degradation of the battery pack 41 progresses linearly with respect to the f4 power of the cumulative travel distance D(km) of the electric vehicle 3.$SOHd = m + Kd \times {E}^{∧} f 3$ (Equation 5) $SOHd = m + Kd \times {D}^{∧} f 4$ (Equation 6) where m is an initial value, and Kd is a discharge degradation rate.

The degradation prediction formula generator 113 fits a plurality of SOH values in time series to determine the discharge degradation rate Kd of the above equation (Equation 5 or Equation 6) and the exponent f3 or f4 of the above equation (Equation 5 or Equation 6). A fixed value (for example, 0.5) may be used for the exponent f3 or f4.

The lifespan predictor 115 can substitute the SOH at which use of the battery pack 41 should be ended (for example, 70%) into the generated degradation prediction formula to predict the period until the SOH at which use of the battery pack 41 should be ended is reached, the number of times of charging until the SOH at which use of the battery pack 41 should be ended is reached, and the number of times of discharging until the SOH at which use of the battery pack 41 should be ended is reached. The SOH at which use of the battery pack 41 should be ended may be defined as a weighted average of SOHs obtained from a storage degradation prediction formula, SOHc obtained from a charge degradation prediction formula, and SOHd obtained from the discharge degradation prediction formula, as shown in the following equation (Equation 7).$SOH = SOHs \times r 1 + SOHc \times r 2 + SOHd \times r 3$ (Equation 7) $r 1 + r 2 + r 3 = 1$ The weighting factors r1, r2, and r3 depend on the use of the battery pack 41. For example, in the battery pack 41 mounted on the electric vehicle 3 or on an energy storage system for frequency regulation (FR) application, the weighting factors r2 and r3 are set to large values, and in the battery pack 41 mounted on an energy storage system for backup application, the weighting factor r1 is set to a large value.

The notifier 116 notifies, via the network 5, the operation management terminal 2 of the delivery business operator or a terminal of a vehicle management department of an analysis result of the battery pack 41 including the remaining life of the battery pack 41, the remaining life being predicted by the lifespan predictor 115.

The degradation rate statistical value calculator 114 calculates a statistical value of the degradation rate of the battery pack 41 based on the time-series battery data of the battery pack 41 and degradation characteristics of cells used in the battery pack 41.

The degradation rate statistical value calculator 114 calculates a statistical value of the storage degradation rate of the battery pack 41 based on the SOC and temperature included in the time-series battery data of the battery pack 41 and the storage degradation characteristics of the cell. The degradation rate statistical value calculator 114 derives the storage degradation rate for each unit time, and calculates any one of a mean, a median, a mode, a standard deviation, and a variance as a statistical value of a plurality of derived storage degradation rates. The unit time is set to, for example, one day or a time less than one day.

The degradation rate statistical value calculator 114 calculates the statistical value of the charge degradation rate of the battery pack 41 based on the SOC, a charge rate, the temperature, and the charge degradation characteristics of the cell. The charge rate is based on the current. The SOC, the current, and temperature are included in the time-series battery data of the battery pack 41. The degradation rate statistical value calculator 114 derives the charge degradation rate for each unit charge amount, and calculates a statistical value of a plurality of derived charge degradation rates. The unit charge amount may be set to, for example, an amount corresponding to the full charge capacity of the battery pack 41.

The degradation rate statistical value calculator 114 calculates the statistical value of the discharge degradation rate of the battery pack 41 based on the SOC, a discharge rate, the temperature, and the discharge degradation characteristics of the cell. The discharge rate is based on the current. The SOC, the current, and the temperature are included in the time-series battery data of the battery pack 41. The degradation rate statistical value calculator 114 derives a discharge degradation rate for each unit discharge amount or each unit travel distance, and calculates a statistical value of a plurality of derived discharge degradation rates. The unit discharge amount may be set to, for example, an amount corresponding to the full charge capacity of the battery pack 41. The unit travel distance may be set to, for example, 100 to 500 km.

As the life of secondary batteries has become longer, changes in a manner of use of secondary batteries before the final life of the secondary batteries is reached (for example, changes from an in-vehicle application to a stationary energy storage application) have been increasing. First use of the secondary battery is use by an initial manner of use, and second use of the secondary battery is use by a manner of use different from the initial manner of use. For example, when the SOH reaches the SOH (for example, 70%) at which first use of the battery pack 41 should be terminated, first use is changed to second use. In general, first use and second use are different from each other in application, but even in the same application, the manner of use may be changed to a manner of use in which a burden is increased or reduced. For example, as an example in which the manner of use is changed to a manner of use in which the burden is reduced, there is a case in which the manner of use is changed from a high-speed EV application to a low-speed EV application. In the example shown in FIG. 7, an example is shown in which the application in second use places a larger burden on the battery pack 41 than the application in first use.

The degradation rate statistical value calculator 114 calculates a statistical value of the degradation rate during second use of the battery pack 41 based on measured or predicted time-series battery data of the battery pack 41 after first use of the battery pack 41 has ended and second use of the battery pack 41 has started, and the degradation characteristics of the cells used in the battery pack 41.

When the measured battery data after the start of second use is used as the time-series battery data of the battery pack 41 after the start of second use, data for a period shorter than that of the time-series battery data during first use (for example, one month from the start of second use) is used as the time-series battery data after the start of second use. In general, since the degradation rate of the battery pack 41 is different between first use and second use, it is necessary to update the degradation prediction formula as early as possible after the start of second use, and the degradation prediction formula is updated before long-term battery data is collected.

When predicted battery data after the start of second use is used as the time-series battery data of the battery pack 41 after the start of second use, the measured battery data of another battery pack undergoing the same life cycle can be used. When the full charge capacity of the other battery pack is different from that of the battery pack 41, it is necessary to convert the battery data of the other battery pack according to a capacity ratio of the two. As the measured battery data of another battery pack, a statistical value of battery data of a plurality of battery packs undergoing the same life cycle may be used. In addition, simulation data at the time of second use may be used instead of using the measured battery data of another battery pack undergoing the same life cycle.

The degradation prediction formula generator 113 corrects a degradation rate K of the degradation prediction formula for first use of the battery pack 41 based on a ratio of a statistical value of the degradation rate in first use calculated from the degradation characteristics of cells used in the battery pack 41 and a statistical value of the degradation rate in second use calculated from the degradation characteristics, and generates the degradation prediction formula for second use.

Since the exponent f depends on battery characteristics and basically does not change depending on the manner of use of the battery pack 41, the exponent f of the degradation prediction formula in first use is used as is as the exponent f of the degradation prediction formula in second use. The exponent f determined by fitting when generating the degradation prediction formula in first use may be used, or a fixed value (for example, 0.5) common to the degradation prediction formula in first use and the degradation prediction formula in second use may be used.

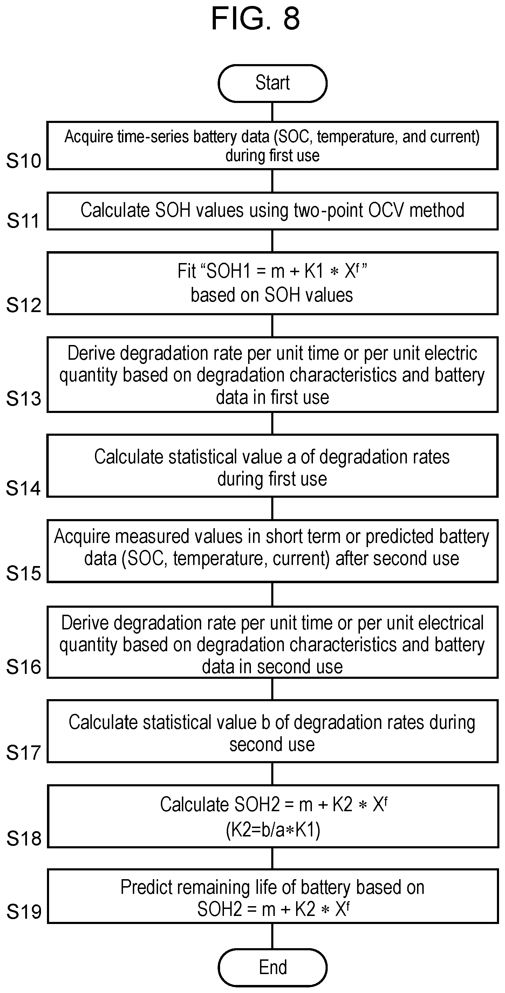

FIG. 8 is a flowchart for describing degradation prediction processing during second use of the battery pack 41 according to the embodiment. The data acquirer 111 acquires the time-series battery data (SOC, temperature, and current) during first use of the battery pack 41 from the data server 4 (S10). For example, battery data from one year or more before the time point at which the use is changed to second use is acquired. The SOH calculator 112 calculates the SOH of the battery pack 41 every certain period (for example, every month) using the two-point OCV method based on the time-series battery data (S11). The degradation prediction formula generator 113 fits a degradation prediction formula (SOH1 = m + K1 × X^f) for first use of the battery pack 41 based on sample data of a plurality of SOH values during first use of the battery pack 41 (S12).

The degradation rate statistical value calculator 114 derives a degradation rate per unit time or per unit electric quantity based on the time-series battery data during first use of the battery pack 41 and the degradation characteristics of cells used in the battery pack 41 (S13). The degradation rate statistical value calculator 114 calculates a statistical value a (for example, a mean value or a standard deviation value) of a plurality of derived degradation rates (S14).

The data acquirer 111 acquires the time-series battery data (SOC, temperature, and current) after the start of second use of the battery pack 41 (S15). The time-series battery data after the start of second use may be measured values in a short term (for example, one month) after the start of second use, or may be predicted values in a short term or a long term. The degradation rate statistical value calculator 114 derives a degradation rate per unit time or per unit electric quantity based on the time-series battery data after the start of second use of the battery pack 41 and the degradation characteristics of cells used in the battery pack 41 (S16). The degradation rate statistical value calculator 114 calculates a statistical value b (for example, a mean value or a standard deviation value) of a plurality of derived degradation rates (S17).

The degradation prediction formula generator 113 calculates a degradation prediction formula (SOH2 = m + K2 × X^f) in second use of the battery pack 41 based on the degradation prediction formula (SOH1 = m + K1 × X^f) in first use and a ratio between the statistical value a of the degradation rate in first use and the statistical value b of the degradation rate in second use, both calculated from the degradation characteristics (S18). The degradation prediction formula generator 113 calculates a degradation rate K2 of the degradation prediction formula (SOH2 = m + K2 × X^f) in second use as shown in the following equation (Equation 8).$K 2 = b / a \times K 1$ (Equation 8) The lifespan predictor 115 substitutes the SOH at which second use of the battery pack 41 should be ended into the calculated degradation prediction formula for second use (SOH2 = m + K2 × X^f), and predicts the period, the number of charges, and the number of discharges until the SOH at which second use should be ended is reached (S19).

As described above, according to the present embodiment, it is possible to predict degradation progression after a change in the manner of use of the battery pack 41 with high accuracy. Since sample data of the SOH in first use is not used to generate the degradation prediction formula in second use, the degradation prediction formula in second use can be generated with high accuracy.

In order to generate the degradation prediction formula of the battery pack 41, at least about 25 to 40 SOH data samples are usually required. Therefore, it takes a long time before the degradation prediction formula in second use can be generated from the SOH data samples after the start of second use. In particular, when a frequency of use of a device in which the battery pack 41 is mounted is low, it takes a long time to collect about 25 to 40 SOH data samples. For example, when the manner of use is changed to that of an energy storage system for backup application, it takes a long time after the start of second use to collect the required number of SOH data samples.

On the other hand, in the present embodiment, a degradation rate in second use is calculated based on SOC, current, and temperature, all of which can always be sampled, and on the storage degradation characteristic map, the charge degradation characteristic map, and the discharge degradation characteristic map, and the degradation rate of the degradation prediction formula in first use is updated, so that the degradation prediction formula in second use can be generated at an early stage. For example, even when the manner of use is changed to the energy storage system for backup application, the degradation rate can be updated early based on SOC, temperature, and the storage degradation characteristic map after the start of second use.

The present disclosure has been described above based on the embodiment. The embodiment is illustrative, and it will be obvious to those skilled in the art that various modifications to combinations of constituent elements and processing processes are possible and that such modifications are also within the scope of the present disclosure.

In the above embodiment, an example in which first use of the battery pack 41 ends and a degradation prediction formula after the start of second use is generated has been described. In this regard, the present disclosure is also applicable to a case where second use of the battery pack 41 ends and a degradation prediction formula after the start of third use is generated. That is, the present disclosure is applicable to a case where an n-th use (n being a natural number) of the battery pack 41 ends and a degradation prediction formula after the start of an (n+1)-th use is generated.

In the above embodiment, the storage degradation characteristic map, the charge degradation characteristic map, and the discharge degradation characteristic map are not divided for each application. However, the storage degradation characteristic map, the charge degradation characteristic map, and the discharge degradation characteristic map may be generated separately for each application. For example, the storage degradation characteristic map, for an in-vehicle application the charge degradation characteristic map for an in-vehicle application, and the discharge degradation characteristic map for an in-vehicle application; the storage degradation characteristic map for an energy storage system used for FR, the charge degradation characteristic map for an energy storage system used for FR, and the discharge degradation characteristic map for the energy storage system for FR application, and the storage degradation characteristic map for an energy storage system used for backup, the charge degradation characteristic map for the energy storage system used for backup, and the discharge degradation characteristic map for the energy storage system for backup application may be generated.

Functions executed by the battery analysis system 1 described above may be incorporated into the management unit 42 of the power supply system 40 in the electric vehicle 3.

In the above embodiment, the electric vehicle 3 is assumed to be a four-wheeled electric vehicle. In this regard, the vehicle may be an electric motorcycle (electric scooter), an electric bicycle, or an electric kick scooter. The electric vehicle includes not only a full-standard electric vehicle but also a low-speed electric vehicle such as a golf cart or a land car. An object on which the battery pack 41 is mounted is not limited to the electric vehicle 3. The object on which the battery pack 41 is mounted includes an electric moving body such as an electric ship, a railway vehicle, a construction machine, and a multicopter (drone), a stationary energy storage system that is charged and discharged under a high load, and medical equipment.

The embodiment may be specified by the following items.

### [Item 1]

A battery analysis system (1), comprising:
a data acquirer (111) that acquires battery data of a secondary battery (41), the battery data being time-series data, the battery data including a current, a temperature, and a state of charge (SOC);
a state of health (SOH) calculator (112) that calculates a plurality of SOH values of the secondary battery (41) based on an SOC difference between two points and a current integration value, the SOC difference and the current integration value being obtained with reference to the battery data;
a degradation prediction formula generator (113) that generates a degradation prediction formula (SOH = m + K × X^f) of the secondary battery (41) by performing curve fitting on the plurality of SOH values calculated; and
a degradation rate statistical value calculator (114) that calculates a statistical value of a degradation rate of the secondary battery (41) based on the battery data of the secondary battery (41) and degradation characteristics of the secondary battery (41), wherein
the degradation rate statistical value calculator (114) calculates a statistical value of a degradation rate in an (n+1)-th use (n being a natural number) of the secondary battery (41) based on (i) the battery data of the secondary battery (41) that is measured or predicted after a start of the (n+1)-th use of the secondary battery (41) following an n-th use of the secondary battery (41), and (ii) the degradation characteristics of the secondary battery (41), and
the degradation prediction formula generator (113) corrects a degradation rate K of the degradation prediction formula in the n-th use of the secondary battery (41) based on a ratio between (i) a statistical value of a degradation rate in the n-th use calculated from the degradation characteristics of the secondary battery (41) and (ii) the statistical value of the degradation rate in the (n+1)-th use calculated from the degradation characteristics, to generate the degradation prediction formula in the (n+1)-th use.

According to this, it is possible to predict degradation progression after a change in a manner of use of the secondary battery (41) with high accuracy.

### [Item 2]

The battery analysis system (1) according to item 1, wherein
the degradation rate statistical value calculator (114) derives a storage degradation rate per unit time of the secondary battery (41) based on the SOC, the temperature, and storage degradation characteristics of the secondary battery (41), the SOC and the temperature being included in the battery data of the secondary battery (41), to calculate a statistical value of a plurality of derived storage degradation rates, and
the degradation prediction formula generator (113) generates a storage degradation prediction formula (SOH = m + K × period^f) of the secondary battery (41).

According to this, it is possible to predict progression of storage degradation after a change in the manner of use of the secondary battery (41) with high accuracy.

### [Item 3]

The battery analysis system (1) according to item 1, wherein
the degradation rate statistical value calculator (114) derives a charge degradation rate per unit charge amount of the secondary battery (41) based on the SOC, a charge rate, the temperature, and charge degradation characteristics of the secondary battery (41), the charge rate being based on the current, the battery data of the secondary battery (41) including the SOC, the current, and the temperature, to calculate a statistical value of a plurality of derived charge degradation rates, and
the degradation prediction formula generator (113) generates a charge degradation prediction formula (SOH = m + K × cumulative charge amount^f) of the secondary battery (41).

According to this, it is possible to predict with high accuracy progression of charge degradation after a change in the manner of use of the secondary battery (41).

### [Item 4]

The battery analysis system (1) according to item 1, wherein
the degradation rate statistical value calculator (114) derives a discharge degradation rate per unit discharge amount of the secondary battery (41) based on the SOC, a discharge rate, the temperature, and discharge degradation characteristics of the secondary battery (41), the discharge rate being based on the current, the SOC, the current, and the temperature being included in the battery data of the secondary battery (41), to calculate a statistical value of a plurality of derived discharge degradation rates, and
the degradation prediction formula generator (113) generates a discharge degradation prediction formula (SOH = m + K × cumulative discharge amount^f) of the secondary battery (41).

According to this, it is possible to predict progression of discharge degradation after a change in the manner of use of the secondary battery (41) with high accuracy.

### [Item 5]

The battery analysis system (1) according to item 1, wherein
the data acquirer (111) acquires the battery data of the secondary battery (41), the battery data being time-series data, the battery data including a current, a temperature, and a state of charge (SOC), and the data acquirer (111) further acquires cumulative travel distance data of a vehicle on which the secondary battery (41) is mounted,
the degradation rate statistical value calculator (114) derives a discharge degradation rate per unit travel distance of the secondary battery (41) based on the SOC, a discharge rate, the temperature, and discharge degradation characteristics of the secondary battery (41), the discharge rate being based on the current, the SOC, the current, and the temperature being included in the battery data of the secondary battery (41), to calculate a statistical value of a plurality of derived discharge degradation rates, and
the degradation prediction formula generator (113) generates a discharge degradation prediction formula (SOH = m + K × cumulative travel distance^f) of the secondary battery (41).

According to this, it is possible to predict the progression of discharge degradation after a change in the manner of use of the secondary battery (41) with high accuracy.

### [Item 6]

The battery analysis system (1) according to any one of items 1 to 5, wherein
the measured battery data of the secondary battery (41) after the start of the (n+1)-th use is data for a shorter period than the battery data of the secondary battery (41) in the n-th use.

According to this, a degradation prediction formula after a change in the manner of use of the secondary battery (41) can be generated at an early stage.

### [Item 7]

A battery analysis method, comprising:
acquiring battery data of a secondary battery (41), the battery data being time-series data, the battery data including a current, a temperature, and a state of charge (SOC);
calculating a plurality of state of health (SOH) values of the secondary battery (41) based on an SOC difference between two points obtained with reference to the battery data and a current integration value;
generating a degradation prediction formula (SOH = m + K × X^f) of the secondary battery (41) by performing curve fitting on a plurality of SOH values calculated; and
calculating a statistical value of a degradation rate of the secondary battery (41) based on battery data of the secondary battery (41) and degradation characteristics of the secondary battery (41), wherein
the calculating of the statistical value of the degradation rate includes calculating a statistical value of a degradation rate in an (n+1)-th use (n being a natural number) of the secondary battery (41) based on (i) the battery data of the secondary battery (41) that is measured or predicted after a start of the (n+1)-th use of the secondary battery (41) following an n-th use of the secondary battery (41), and (ii) the degradation characteristics of the secondary battery (41); and
the generating step of generating the degradation prediction formula includes generating the degradation prediction formula in the (n+1)-th use by correcting a degradation rate K of the degradation prediction formula in the n-th use of the secondary battery (41) based on a ratio between (i) a statistical value of a degradation rate in the n-th use calculated from the degradation characteristics of the secondary battery (41) and (ii) the statistical value of the degradation rate in the (n+1)-th use calculated from the degradation characteristics.

According to this, it is possible to predict degradation progression after a change in a manner of use of the secondary battery (41) with high accuracy.

### [Item 8]

A battery analysis program that causes a computer to execute operations comprising:
processing of acquiring battery data of a secondary battery (41), the battery data being time-series data, the battery data including a current, a temperature, and a state of charge (SOC);
processing of calculating a plurality of state of health (SOH) values of the secondary battery (41) based on an SOC difference between two points obtained with reference to the battery data and a current integration value;
processing of generating a degradation prediction formula (SOH = m + K × X^f) of the secondary battery (41) by performing curve fitting on the plurality of SOH values calculated; and
processing of calculating a statistical value of a degradation rate of the secondary battery (41) based on battery data of the secondary battery (41) and degradation characteristics of the secondary battery (41), wherein
the processing of calculating the statistical value of the degradation rate includes calculating a statistical value of a degradation rate in an (n+1)-th use (n being a natural number) of the secondary battery (41) based on (i) the battery data of the secondary battery (41) that is measured or predicted after a start of the (n+1)-th use of the secondary battery (41) following an n-th use of the secondary battery (41), and (ii) the degradation characteristics of the secondary battery (41); and
the processing of generating the degradation prediction formula includes generating the degradation prediction formula in the (n+1)-th use by correcting a degradation rate K of the degradation prediction formula in the n-th use of the secondary battery (41) based on a ratio between (i) a statistical value of a degradation rate in the n-th use calculated from the degradation characteristics of the secondary battery (41) and (ii) the statistical value of the degradation rate in the (n+1)-th use calculated from the degradation characteristics of the secondary battery (41).

According to this, it is possible to predict, with high accuracy, degradation progression after a change in a manner of use of the secondary battery (41).

### REFERENCE MARKS IN THE DRAWINGS

- 1: battery analysis system
- 1a: calculation server
- 1b: degradation characteristic holding server
- 2: operation management terminal
- 3: electric vehicle
- 4: data server
- 5: network
- 11: processor
- 111: data acquirer
- 112: SOH calculator
- 113: degradation prediction formula generator
- 114: degradation rate statistical value calculator
- 115: lifespan predictor
- 116: notifier
- 12: storage
- 121: battery degradation characteristic holder
- 13: communication unit
- 30: vehicle controller
- 31f: front wheel
- 31r: rear wheel
- 32f: front axle
- 32r: rear axle
- 33: transmission
- 34: motor
- 35: inverter
- 36: vehicle speed sensor
- 37: wireless communication unit
- 37a: antenna
- 40: power supply system
- 41: battery pack
- 42: management unit

## Claims

1. A battery analysis system, comprising:
a data acquirer that acquires battery data of a secondary battery, the battery data being time-series data, the battery data including a current, a temperature, and a state of charge (SOC);
a state of health (SOH) calculator that calculates a plurality of SOH values of the secondary battery based on an SOC difference between two points and a current integration value, the SOC difference and the current integration value being obtained with reference to the battery data;
a degradation prediction formula generator that generates a degradation prediction formula (SOH = m + K × X^f) of the secondary battery by performing curve fitting on the plurality of SOH values calculated; and
a degradation rate statistical value calculator that calculates a statistical value of a degradation rate of the secondary battery based on the battery data of the secondary battery and degradation characteristics of the secondary battery, wherein
the degradation rate statistical value calculator calculates a statistical value of a degradation rate in an (n+1)-th use of the secondary battery based on (i) the battery data of the secondary battery that is measured or predicted after a start of the (n+1)-th use of the secondary battery following an n-th use of the secondary battery and (ii) the degradation characteristics of the secondary battery, n being a natural number, and
the degradation prediction formula generator corrects a degradation rate K of the degradation prediction formula in the n-th use of the secondary battery based on a ratio between (i) a statistical value of a degradation rate in the n-th use calculated from the degradation characteristics of the secondary battery and (ii) the statistical value of the degradation rate in the (n+1)-th use calculated from the degradation characteristics, to generate the degradation prediction formula in the (n+1)-th use.

2. The battery analysis system according to claim 1, wherein
the degradation rate statistical value calculator derives a storage degradation rate per unit time of the secondary battery based on the SOC, the temperature, and storage degradation characteristics of the secondary battery, the SOC and the temperature being included in the battery data of the secondary battery, to calculate a statistical value of a plurality of derived storage degradation rates, and
the degradation prediction formula generator generates a storage degradation prediction formula (SOH = m + K × period^f) of the secondary battery.

3. The battery analysis system according to claim 1, wherein
the degradation rate statistical value calculator derives a charge degradation rate per unit charge amount of the secondary battery based on the SOC, a charge rate, the temperature, and charge degradation characteristics of the secondary battery, the charge rate being based on the current, the battery data of the secondary battery including the SOC, the current, and the temperature, to calculate a statistical value of a plurality of derived charge degradation rates, and
the degradation prediction formula generator generates a charge degradation prediction formula (SOH = m + K × cumulative charge amount^f) of the secondary battery.

4. The battery analysis system according to claim 1, wherein
the degradation rate statistical value calculator derives a discharge degradation rate per unit discharge amount of the secondary battery based on the SOC, a discharge rate, the temperature, and discharge degradation characteristics of the secondary battery, the discharge rate being based on the current, the SOC, the current, and the temperature being included in the battery data of the secondary battery, to calculate a statistical value of a plurality of derived discharge degradation rates, and
the degradation prediction formula generator generates a discharge degradation prediction formula (SOH = m + K × cumulative discharge amount^f) of the secondary battery.

5. The battery analysis system according to claim 1, wherein
the data acquirer acquires the battery data of the secondary battery, the battery data being time-series data, the battery data including a current, a temperature, and a state of charge (SOC), and the data acquirer further acquires cumulative travel distance data of a vehicle on which the secondary battery is mounted,
the degradation rate statistical value calculator derives a discharge degradation rate per unit travel distance of the secondary battery based on the SOC, a discharge rate, the temperature, and discharge degradation characteristics of the secondary battery, the discharge rate being based on the current, the SOC, the current, and the temperature being included in the battery data of the secondary battery, to calculate a statistical value of a plurality of derived discharge degradation rates, and
the degradation prediction formula generator generates a discharge degradation prediction formula (SOH = m + K × cumulative travel distance^f) of the secondary battery.

6. The battery analysis system according to any one of claims 1 to 5, wherein
the measured battery data of the secondary battery after the start of the (n+1)-th use is data for a shorter period than the battery data of the secondary battery in the n-th use.

7. A battery analysis method, comprising:
acquiring battery data of a secondary battery, the battery data being time-series data, the battery data including a current, a temperature, and a state of charge (SOC);
calculating a plurality of state of health (SOH) values of the secondary battery based on an SOC difference between two points and a current integration value obtained with reference to the battery data;
generating a degradation prediction formula (SOH = m + K × X^f) of the secondary battery by performing curve fitting on the plurality of SOH values calculated; and
calculating a statistical value of a degradation rate of the secondary battery based on the battery data of the secondary battery and degradation characteristics of the secondary battery, wherein
the calculating of the statistical value of the degradation rate includes calculating a statistical value of a degradation rate in an (n+1)-th use of the secondary battery based on (i) the battery data of the secondary battery that is measured or predicted after a start of the (n+1)-th use of the secondary battery following an n-th use of the secondary battery, and (ii) the degradation characteristics of the secondary battery, n being a natural number, and
the generating of the degradation prediction formula includes generating the degradation prediction formula in the (n+1)-th use by correcting a degradation rate K of the degradation prediction formula in the n-th use of the secondary battery based on a ratio between (i) a statistical value of a degradation rate in the n-th use calculated from the degradation characteristics of the secondary battery and (ii) the statistical value of the degradation rate in the (n+1)-th use calculated from the degradation characteristics.

8. A battery analysis program that causes a computer to execute operations comprising:
processing of acquiring battery data of a secondary battery, the battery data being time-series data, the battery data including a current, a temperature, and a state of charge (SOC);
processing of calculating a plurality of state of health (SOH) values of the secondary battery based on an SOC difference between two points and a current integration value obtained with reference to the battery data;
processing of generating a degradation prediction formula (SOH = m + K × X^f) of the secondary battery by performing curve fitting on the plurality of SOH values calculated; and
processing of calculating a statistical value of a degradation rate of the secondary battery based on battery data of the secondary battery and degradation characteristics of the secondary battery, wherein
the processing of calculating the statistical value of the degradation rate includes calculating a statistical value of a degradation rate in an (n+1)-th use of the secondary battery based on (i) the battery data of the secondary battery that is measured or predicted after a start of the (n+1)-th use of the secondary battery following an n-th use of the secondary battery, and (ii) the degradation characteristics of the secondary battery, n being a natural number, and
the processing of generating the degradation prediction formula includes generating the degradation prediction formula in the (n+1)-th use by correcting a degradation rate K of the degradation prediction formula in the n-th use of the secondary battery based on a ratio between (i) a statistical value of a degradation rate in the n-th use calculated from the degradation characteristics of the secondary battery and (ii) the statistical value of the degradation rate in the (n+1)-th use calculated from the degradation characteristics.
